Europäisches Patentamt

European Patent Office

Office européen des brevets

(19)

(11) Numéro de publication : **0 048 661**
**B1**

(12)    # FASCICULE DE BREVET EUROPÉEN

(45) Date de publication du fascicule du brevet :
20.02.85

(51) Int. Cl.⁴ : **H 03 D   3/00, H 04 N   5/93**

(21) Numéro de dépôt : **81401417.1**

(22) Date de dépôt : **11.09.81**

(54) **Démodulateur d'un signal modulé en fréquence.**

(30) Priorité : 16.09.80 FR 8019921

(43) Date de publication de la demande :
31.03.82 Bulletin 82/13

(45) Mention de la délivrance du brevet :
20.02.85 Bulletin 85/08

(84) Etats contractants désignés :
**AT BE CH DE GB IT LI LU NL SE**

(56) Documents cités :
**BE-A-  674 935**
**FR-A- 2 400 298**
**US-A- 3 629 716**
**US-A- 3 978 416**
**US-A- 4 101 837**

(73) Titulaire : **THOMSON-LGT LABORATOIRE GENERAL**
**DES TELECOMMUNICATIONS**
**51, boulevard de la République**
**F-78400 Chatou (FR)**

(72) Inventeur : **Favreau, Michel**
**Thomson-CSF SCPI 173, bld Haussmann**
**F-75360 Paris Cedex 08 (FR)**
Inventeur : **Margulnaud, André**
**Thomson-CSF SCPI 173, bld Haussmann**
**F-75360 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

## Description

La présente invention concerne les démodulateurs d'un signal modulé en fréquence, et en particulier ceux utilisés dans les systèmes de télévision.

Il est actuellement connu de démoduler des signaux modulés en fréquence à l'aide de discriminateurs de fréquence classiques. Mais ces discriminateurs classiques se comportent du point de vue de la résistance au bruit comme des démodulateurs d'amplitude de largeur de bande constante. Autrement dit, le rapport signal sur bruit qui en résulte est proportionnel à la largeur de bande de fréquence du signal à démoduler.

Or le signal à démoduler peut présenter à long terme une bande de fréquence totale très importante, ce qui engendre un mauvais rapport signal sur bruit. Cette bande de fréquence totale occupée par le signal constitue le « spectre à long terme ».

La présente invention a pour objet d'améliorer très nettement le rapport signal sur bruit des discriminateurs classiques en tenant compte, à chaque instant, de la fréquence instantanée et de la largeur instantanée de la bande de fréquence occupée par le signal à démoduler.

En effet, lorsque les variations de fréquences sont très lentes devant la fréquence centrale de l'onde modulée, il peut être considéré une largeur de bande « utile » centrée sur la fréquence instantanée du signal et se déplaçant relativement lentement dans la bande totale occupée par le signal. Cette bande de fréquence « utile » constitue le spectre à « court terme ».

Le brevet FR-A-2 400 298 décrit un dispositif démodulateur qui réduit le bruit en mettant en œuvre un filtre passe-bande constitué de deux parties :

— un premier filtre passe-bande dont la fréquence centrale est commandée pour suivre la fréquence instantanée du signal modulé lorsque les variations de cette fréquence sont lentes ; la largeur de bande de ce filtre est étroite par rapport à la largeur de bande maximale du signal modulé. Ainsi le bruit est réduit ;

— un deuxième filtre passe-bande dont la largeur de bande est égale à la largeur de bande maximale du signal est commuté en parallèle sur le premier filtre, afin de le rendre inopérant, quand les variations de la fréquence sont rapides, et nécessitent donc une bande passante importante.

La bande passante de ce dispositif n'a donc que deux valeurs possibles. Dans les cas où elle est trop faible le signal démodulé est distordu. Dans les cas où elle est trop grande elle laisse passer du bruit. Le dispositif selon l'invention a pour but de remédier à ces inconvénients.

Selon l'invention, un démodulateur d'un signal modulé en fréquence, comportant des moyens de filtrage ayant une première et une deuxième entrée de commande, une troisième entrée recevant le signal à démoduler et une sortie ; un discriminateur de fréquence ayant une entrée reliée à la sortie des moyens de filtrage et une sortie restituant le signal de modulation ; un dispositif de commande ayant une première et une deuxième sortie respectivement reliées aux première et deuxième entrées des moyens de filtrage pour commander respectivement sa fréquence centrale ou sa largeur de bande respectivement en fonction de la fréquence instantanée $F_i$ du signal modulé et de la vitesse de variation de cette fréquence $F_i$, est caractérisé en ce que les moyens de filtrage comportent un filtre passe-bande à fréquence centrale et bande passante commandables, et en ce que le dispositif de commande comporte des moyens de calcul pour calculer une valeur $b_u$ de la largeur instantanée de la bande de fréquence occupée par le signal modulé, en fonction de la vitesse de variation du signal de modulation, et fournir un signal fonction de cette valeur $b_u$ sur la deuxième sortie du dispositif de commande afin de régler la largeur de bande du filtre à la valeur $b_u$.

L'invention sera mieux comprise et d'autres caractéristiques apparaîtront à l'aide de la description qui suit, en référence aux figures annexées.

La figure 1 représente un premier mode de réalisation du démodulateur de fréquence selon l'invention.

La figure 2 représente un deuxième mode de réalisation du démodulateur de fréquence selon l'invention, plus particulièrement adapté à la démodulation d'un signal de télévision.

La figure 3 représente un troisième mode de réalisation du démodulateur de fréquence selon l'invention.

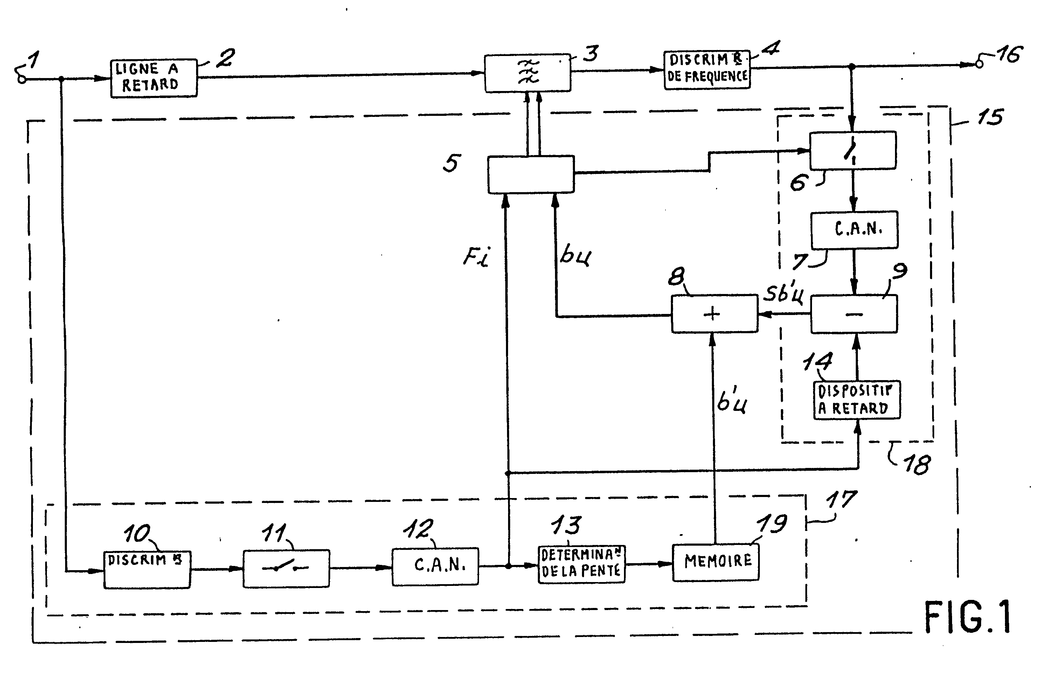

Le premier mode de réalisation du démodulateur selon l'invention, décrit sur la figure 1, comporte deux voies de traitement.

Une première voie est constituée d'une ligne à retard 2, d'un filtre 3 à accord variable, et d'un discriminateur de fréquence classique 4, respectivement disposés en série entre une borne d'entrée, 1, destinée à recevoir un signal modulé en fréquence convenablement amplifié et préfiltré, et une borne de sortie 16 destinée à fournir le signal de modulation.

Le filtre 3 est, selon le principe de l'invention, un filtre passe-bande ayant deux entrées de commande destinées à recevoir deux signaux de commande d'accord (fréquence centrale et largeur de bande passante) fonctions de la fréquence instantanée et de la bande de fréquence « utile » du signal modulé. Ainsi, grâce à cette adaptation de l'accord, le rapport signal sur bruit engendré par le discriminateur de fréquence 4 est nettement meilleur que celui obtenu lorsque le filtre est à accord fixe. En effet, lorsque le filtre est à accord fixe, il présente une bande passante fixe au moins égale à la bande totale du signal modulé.

Le retard apporté par la ligne à retard 2 correspond au temps nécessaire à une deuxième voie du démodulateur pour fournir le signal de commande d'accord du filtre.

Cette deuxième voie est constituée d'un dispositif de détermination 17 de la fréquence instantanée $F_i$ et de la bande de fréquence « utile » $b'_u$ du signal, ayant une entrée reliée à la borne d'entrée 1, une première sortie délivrant $F_i$, et une deuxième sortie délivrant $b'_u$, et d'un circuit de commande 5 ayant une première entrée connectée à la première sortie du dispositif de détermination 17, une deuxième entrée couplée à la deuxième sortie du dispositif de détermination 17 à travers un sommateur 8, et deux sorties reliées respectivement aux deux entrées de commande du filtre 3. Les sorties du circuit de commande 5 fournissent les signaux de commande d'accord du filtre 3 en fonction de $F_i$ et de $b'_u$.

Le dispositif de détermination 17 est constitué d'un discriminateur de fréquence classique 10, d'un échantillonneur 11, d'un convertisseur analogique-numérique 12, d'un dispositif de détermination de pente 13, et d'une mémoire 19.

Le discriminateur de fréquence classique 10 comporte une entrée reliée à la borne d'entrée 1 sur laquelle est reçu le signal à démoduler et une sortie qui fournit le signal de modulation. Celui-ci est échantillonné par l'échantillonneur 11, puis converti en une suite de valeurs numériques par le convertisseur analogique-numérique 12. La sortie de ce convertisseur analogique-numérique 12, reliée à la première entrée du circuit de commande 5, délivre des échantillons numériques du signal de modulation qui correspondent aux valeurs de la fréquence instantanée $F_i$ du signal modulé.

Quant aux valeurs de la largeur de bande « utile » $b'_u$, elles sont fournies par la mémoire 19 dont l'entrée d'adresse est connectée à la sortie du dispositif de détermination de pente 13. Ce dispositif de détermination 13 dont l'entrée est connectée à la sortie du convertisseur analogique-numérique 12, fournit sur sa sortie les valeurs de la pente de la courbe amplitude-temps du signal de modulation. Ces valeurs de pente sont déterminées par la méthode des moindres carrés à partir de cinq échantillons.

A chaque valeur de pente délivrée par le dispositif de détermination 13, il est fourni par la mémoire 19 la valeur de bande « utile » $b'_u$ correspondante. Cette valeur $b'_u$ est approximative, car le procédé de calcul est simplifié pour faciliter sa mise en œuvre, d'autre part, dans certains cas, le bruit peut fausser l'estimation de $b'_u$, c'est pourquoi il est prévu un dispositif de correction qui modifie les valeurs délivrées par la mémoire 19 en tenant compte d'une estimation $\delta b'_u$ de l'erreur engendrée sur ces valeurs.

Pour cela, le dispositif de détermination auxiliaire comporte, pour modifier les valeurs de bande « utile » $b'_u$, d'une part un dispositif d'estimation 18 de la valeur de l'erreur $\delta b'_u$ et d'autre part le sommateur 8.

Le dispositif d'estimation 18, dont les première et deuxième entrées sont respectivement reliées à la sortie du discriminateur de fréquence 4, et à la sortie du convertisseur numérique-analogique 12, compare les signaux de modulation fournis par chacune des voies de traitement. Ainsi, le dispositif d'estimation 18 est constitué d'un échantillonneur 6 dont l'entrée est reliée à la sortie du discriminateur de fréquence 4, d'un convertisseur analogique-numérique 7 ayant une entrée connectée à la sortie de l'échantillonneur 6, d'un dispositif à retard 14 ayant une entrée reliée à la sortie du convertisseur analogique-numérique 12, et d'un soustracteur 9 ayant une première et une deuxième entrée connectées à la sortie du convertisseur analogique-numérique 7 et à la sortie du dispositif à retard 14.

L'échantillonneur 6 délivre des échantillons du signal de modulation fourni par la sortie du discriminateur de fréquence 4. Ces échantillons sont ensuite convertis en valeurs numériques par le convertisseur analogique-numérique 7, puis comparés par le soustracteur 9 aux échantillons fournis par le convertisseur analogique-numérique 12, c'est-à-dire aux échantillons du signal de modulation délivré par le discriminateur de fréquence 10. Le dispositif à retard 14 possède un retard équivalent à la différence du temps de traitement pour élaborer les échantillons à comparer.

Le soustracteur 9 fournit donc un signal d'erreur, qui est utilisé comme une estimation $\delta b'_u$ de l'erreur par défaut affectant les valeurs de bande « utile » $b'_u$ déterminées par le dispositif de détermination 17. Le sommateur 8 dont la première et la deuxième entrée sont respectivement reliées à la sortie du soustracteur 9 et à la sortie de la mémoire 19, additionne $b'_u$ à $\delta b'_u$ et fournit $b_u = b'_u + \delta b'_u$ sur sa sortie.

La sortie du sommateur 8 étant connectée à la deuxième entrée du circuit de commande 5, ce circuit délivre deux signaux de commande d'accord du filtre 3 en fonction de $F_i$ et de $b_u$.

La fréquence d'horloge de l'échantillonneur 6 est commandée par un signal fourni par le circuit de commande 5 afin de conserver le synchronisme entre les échantillons sortant de l'échantillonneur 6 et ceux sortant de l'échantillonneur 11 en dépit des variations de phase causées par les variations des caractéristiques du filtre 3.

Les moyens de correction 18 ne peuvent détecter que les distorsions du signal provoquées par une largeur de bande trop faible. Ils ne peuvent donc corriger qu'une erreur par défaut commise sur l'estimation de $b_u$. Une erreur par excès est moins gênante, elle se traduit par la présence d'un peu plus de bruit dans le cas où la largeur de bande « utile » $b_u$ est optimale.

Dans la suite du texte, l'ensemble d'éléments constitué du dispositif de détermination 17, du circuit de commande 5, du sommateur 8 et du dispositif d'estimation d'erreur 18, sera appelé dispositif de commande 15 d'accord du filtre.

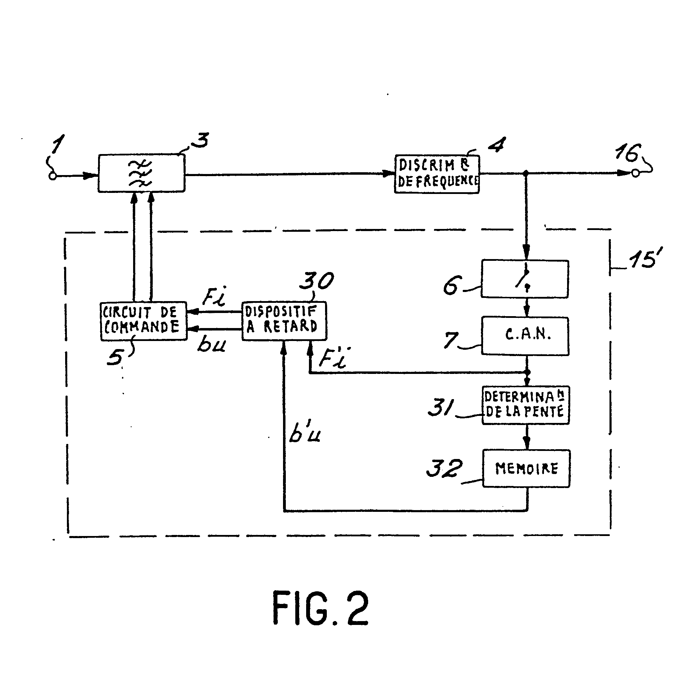

Sur la figure 2 est représenté un second mode de réalisation du démodulateur selon l'invention, plus particulièrement adapté à un signal de télévision modulé en fréquence, et qui est plus simple que le précédent.

En télévision, il est connu que la corrélation entre lignes proches est grande, ce qui permet d'obtenir une estimation a priori de la bande « utile » du signal. En effet, il suffit d'utiliser pour chaque ligne les valeurs de bande « utile » déterminées à la ligne précédente.

Pour cela, le dispositif de commande 15 de l'accord du filtre est modifié comme représenté sur la figure 2.

Sur cette figure, la borne 1 destinée à recevoir le signal modulé est reliée directement à l'entrée du filtre 3 à accord variable. La ligne à retard 2 a donc été supprimée. La sortie du filtre 3 est toujours couplée à la borne 16 à travers le discriminateur de fréquence 4.

Un dispositif de commande d'accord 15' remplit les mêmes fonctions que le dispositif de commande 15 représenté sur la figure 1. Mais la structure des deux dispositifs est différente.

Seuls, l'échantillonneur 6, le convertisseur analogique-numérique 7, et le circuit de commande 5 ont été conservés. Un dispositif à retard 30 et un dispositif de détermination de pente 31 et une mémoire 32 ont été rajoutés.

Le fonctionnement de ce dispositif de commande 15' est le suivant :

Le signal de modulation délivré par le discriminateur de fréquence 4 est échantillonné par l'échantillonneur 6, et converti en valeur numérique par le convertisseur analogique-numérique 7.

Ce convertisseur 7, dont la sortie est reliée à une première entrée du dispositif à retard 30, délivre donc des échantillons numériques correspondant à des valeurs $F'_i$ de la fréquence instantanée du signal de modulation. Le dispositif de détermination de pente 31 et la mémoire 32 sont couplés en série entre la sortie du convertisseur analogique-numérique 7 et une deuxième entrée du dispositif à retard 30 et ont la même fonction que les éléments 13 et 19 représentés sur la figure 1. Ils fournissent donc à la deuxième entrée du dispositif à retard 30 les valeurs $b'_u$ de la bande « utile » du signal.

Le dispositif à retard 30, de retard égal à une durée d'une ligne de télévision, comporte deux sorties respectivement couplées aux deux entrées du circuit de commande 5. Ainsi, la sortie de ce circuit de commande 5 délivre deux signaux de commande d'accord du filtre en fonction des valeurs $F_i$ et $b_u$ prises égales aux valeurs $F'_i$ et $b'_u$ de la fréquence instantanée et de la bande « utile » du signal correspondant à la ligne précédente.

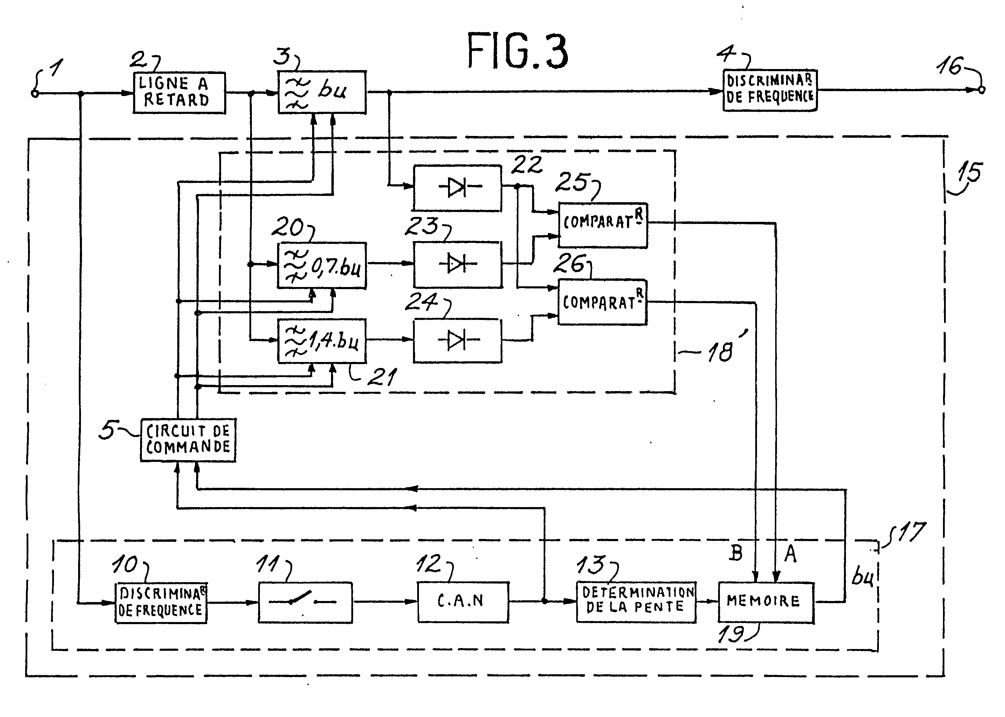

La figure 3 représente un troisième mode de réalisation de l'invention analogue à celui de la figure 1, mais où les moyens d'estimation d'erreur 18 décrits précédemment sont remplacés par des moyens d'estimation 18' fonctionnant selon un principe différent. La correction de $b'_u$ est effectuée non pas en additionnant à cette valeur une correction, mais en modifiant l'adresse fournie à la mémoire 19 pour y lire une autre valeur de $b'_u$.

L'erreur est estimée non pas en comparant le signal démodulé filtré et le signal démodulé non filtré, mais en comparant l'énergie du signal, non démodulé, filtré en laissant passer une bande de largeur $b_u$, avec les énergies des signaux obtenus en laissant passer une bande de largeur $0,7 \cdot b_u$ et une bande de largeur $1,4 \cdot b_u$. Si l'énergie du signal à la sortie des filtres de largeur de bande $b_u$ et $1,4 \cdot b_u$ n'est pas identique, la valeur de $b_u$ est trop petite. Si l'énergie du signal à la sortie du filtre de largeur de bande $b_u$ est égale à l'énergie du signal à la sortie du filtre de largeur de bande $0,7 \cdot b_u$ la valeur de $b_u$ est trop grande. Dans tous les autres cas, la valeur de $b_u$ peut être considérée comme correcte.

Les moyens d'estimation d'erreur 18' comportent un filtre passe-bande 20 de largeur de bande $0,7 \cdot b_u$ et un filtre passe-bande 21 de largeur de bande $1,4 \cdot b_u$. Ces deux filtres reçoivent comme le filtre passe-bande 3 de largeur de bande $b_u$, deux signaux fonctions des valeurs $F_i$ et $b_u$, qui commandent respectivement leur fréquence centrale et leur bande passante. D'autre part, ils reçoivent le signal modulé fourni par la ligne à retard 2. La sortie du filtre 3 de largeur de bande $b_u$ est connectée, d'une part au discriminateur de fréquence 4 et d'autre part à un premier détecteur 22. La sortie du filtre passe-bande de largeur de bande $0,7 \cdot b_u$ est connectée à un deuxième détecteur 23, et la sortie du filtre passe-bande de largeur de bande $1,4 \cdot b_u$ est connectée à un troisième détecteur 24. Les sorties des premier et deuxième détecteurs 22 et 23 sont respectivement connectées aux deux entrées d'un premier comparateur 25 qui fournit un signal logique A, égal à 1 par exemple, si les signaux présents sur ces entrées sont de même valeur. Ce signal logique est fourni à une première entrée d'adressage de la mémoire 19.

Les sorties des premier et troisième détecteurs, 22 et 24, sont reliées respectivement à la première et à la deuxième entrée d'un deuxième comparateur 26 qui fournit un signal logique B, égal à 1 par exemple, quand la valeur présente sur la deuxième entrée est supérieure à la valeur présente sur la première entrée. Ce signal logique est fourni à une deuxième entrée d'adressage de la mémoire 19. Celle-ci possède une troisième entrée d'adresse recevant la valeur de la vitesse de variation du signal de modulation calculée par le dispositif de détermination de pente 13.

Les filtres à accord variable utilisés peuvent être soit des filtres mécaniques dont l'accord est effectué à l'aide de selsyns, soit des filtres électriques du type circuit bouchon ou filtre YIG (Ytrium Iron-Garnet).

L'invention n'est pas limitée aux modes de réalisation décrits et représentés, de nombreuses variantes de réalisation sont possibles sans pour autant sortir du cadre de l'invention tel que défini par les revendications, en particulier en ce qui concerne la conception d'un filtre adaptable et d'un dispositif de détermination de la fréquence instantanée et de la bande passante « utile » du signal modulé.

**Revendications**

1. Démodulateur d'un signal modulé en fréquence, comportant des moyens de filtrage (3) ayant une première et une deuxième entrée de commande, une troisième entrée recevant le signal à démoduler et une sortie ; un discriminateur de fréquence (4) ayant une entrée reliée à la sortie des moyens de filtrage (3) et une sortie restituant le signal de modulation ; un dispositif de commande (15 ou 15') ayant une première et une deuxième sortie respectivement reliées aux première et deuxième entrées des moyens de filtrage (3) pour commander respectivement sa fréquence centrale ou sa largeur de bande respectivement en fonction de la fréquence instantanée $F_i$ du signal modulé et de la vitesse de variation de cette fréquence $F_i$, caractérisé en ce que les moyens de filtrage (3) comportent un filtre passe-bande (3) à fréquence centrale et bande-passante commandables, et en ce que le dispositif de commande (15 ou 15') comporte des moyens de calcul pour calculer une valeur $b_u$ de la largeur instantanée de la bande de fréquence occupée par le signal modulé, en fonction de la vitesse de variation du signal de modulation, et fournir un signal fonction de cette valeur $b_u$ sur la deuxième sortie du dispositif de commande (15 ou 15') afin de régler la largeur de bande du filtre (3) à la valeur $b_u$.

2. Démodulateur selon la revendication 1 caractérisé en ce que les moyens de calcul comportent un dispositif de calcul (13 et 19) pour calculer une valeur approchée $b'_u$ de la largeur instantanée de la bande de fréquence occupée par le signal modulé, et un dispositif (18) d'estimation d'une valeur absolue $\delta b'_u$ de l'erreur commise sur la valeur $b'_u$ quand celle-ci est entâchée d'une erreur par défaut ; en ce que cette valeur $\delta b'_u$ est estimée en faisant la différence entre le signal de modulation extrait du signal modulé filtré par le filtre (3) et le signal de modulation extrait du signal modulé non filtré ; et en ce que les moyens de calcul comportent un sommateur (8) ayant une première et une deuxième entrée recevant respectivement les valeurs $b'_u$ et $\delta b'_u$ et une sortie fournissant la valeur $b_u = b'_u + \delta b'_u$.

3. Démodulateur selon la revendication 1, pour démoduler un signal de télévision, caractérisé en ce que les moyens de calcul comportent un premier dispositif de calcul (6 et 7) pour fournir une valeur $F'_i$ de la fréquence instantanée du signal modulé et un deuxième dispositif de calcul (31 et 32) pour fournir une valeur $b'_u$ de la largeur instantanée de la bande occupée par le signal modulé, et un dispositif à retard (30) retardant les valeurs $F'_i$ et $b'_u$ d'un temps correspondant à une ligne d'image, pour constituer les valeurs $F_i$ et $b_u$.

4. Démodulateur selon la revendication 1, caractérisé en ce que les moyens de calcul comportent un dispositif de calcul (13 et 19) pour calculer la valeur $b_u$ en fonction de la vitesse de variation du signal de modulation et en fonction de deux signaux logiques A et B, et des moyens de correction (18') comportant : deux filtres passe-bande (20 et 21) ayant chacun deux entrées de commande reliées respectivement à la première et à la deuxième sortie du dispositif de commande (15') afin de régler leur fréquence centrale à la valeur $F_i$ et leur largeur de bande passante respectivement aux valeurs $0,7 \cdot b_u$ et $1,4 \cdot b_u$, ayant chacun une entrée de signal commune avec le filtre (3) de largeur de bande passante $b_u$, et ayant chacun une sortie ; un premier, un deuxième et un troisième détecteur (22, 23, 24) reliés respectivement aux sorties des filtres de largeur de bande $b_u$, $0,7 \cdot b_u$ et $1,4 \cdot b_u$, pour déterminer la valeur de l'énergie des signaux présents sur ces sorties : un premier comparateur (25) ayant deux entrées reliées respectivement aux sorties des deux premiers détecteurs (22 et 23) et ayant une sortie fournissant le signal logique A au dispositif de calcul (13 et 19) quand l'énergie détectée par le premier détecteur est égale à l'énergie détectée par le deuxième détecteur ; un deuxième comparateur (26) ayant deux entrées reliées respectivement aux sorties du premier et du troisième détecteurs (22 et 24) et ayant une sortie fournissant le signal logique B au dispositif de·calcul (13 et 19) quand l'énergie détectée par le premier détecteur est inférieure à l'énergie détectée par le troisième détecteur ; en ce que, si le dispositif de calcul (13 et 19) reçoit le signal logique A, la valeur $b_u$ qu'il fournit est plus faible qu'en l'absence du signal À ; et en ce que, si le dispositif de calcul (13 et 19) reçoit le signal logique B, la valeur $b_u$ qu'il fournit est plus élevée qu'en l'absence du signal B.

5. Démodulateur selon la revendication 2, caractérisé en ce que le dispositif d'estimation (18) comporte : un échantillonneur (6) ayant une entrée couplée à la sortie du discriminateur de fréquence (4) ; un convertisseur analogique-numérique (7) ayant une entrée couplée à la sortie de l'échantillonneur (6) ; un dispositif à retard (14) ayant une entrée recevant la valeur $F_i$, et une sortie, pour restituer cette valeur $F_i$ avec un retard tel qu'elle correspond au même échantillon de signal modulé que la valeur fournie par la sortie du convertisseur (7) ; et un soustracteur (9) ayant une première et une deuxième entrée respectivement couplées à la sortie du convertisseur analogique-numérique (7) et à la sortie du dispositif à retard (14), et une sortie couplée à la deuxième entrée du sommateur (8) pour lui fournir la valeur $\delta b'_u$.

**Claims**

1. Demodulator of a frequency modulated signal, comprising filtering means (3) having a first and a second control input, a third input receiving the signal to be demodulated and an output ; a frequency discriminator (4) having an input connected to the output of the filtering means (3) and an output reconstituting the modulation signal ; a control device (15 or 15') having a first and a second output respectively connected to the first and second inputs of the filtering means (3) in order to control its initial frequency or its band width respectively in function of the instantaneous frequency $F_i$, of the modulated frequency and the variation speed of this frequency $F_i$, characterized in that the filtering means (3) comprise a pass-band filter (3) at central frequency and controllable passing-band, and in that the control device (15 or 15') comprises calculating means to calculate a value $b_u$ of the instantaneous width of the frequency band occupied by the modulated signal, in function of the variation speed of the modulation signal, and supplies a signal as function of this value $b_u$ on a second output of the control device (15 or 15') in order to adjust the band width (3) to value $b_u$.

2. Demodulator according to claim 1, characterized in that the calculating means comprising a calculating device (13 or 19) to calculate an approximative value $b'_u$ of the instantaneous width of the frequency band occupied by the modulated signal and an estimation device (18) of an absolute value $\delta b'_u$ of the error made on the value $b'_u$, when it is affected by an error by default ; in that this value $\delta b'_u$ is estimated by making the difference between the modulation signal extracted from the modulated signal filtered by the filter (3) and the modulation filter extracted from non-filtered modulated signal ; and in that the calculating means comprise a sommator (8) having a first and a second input receiving respectively the values $b'_u$ and $\delta b'_u$ and an output supplying the value $b_u = b'_u + \delta b'_u$.

3. Demodulator according to claim 1, to demodulate a television signal, characterized in that the calculating means comprise a first calculating device (6 and 7) to supply a value $F'_i$ of the instantaneous frequency of the modulated signal and a second calculating device (31 and 32) to supply a value $b'_u$ of the instantaneous width of the band occupied by the modulated signal, and a delay device delaying the value $F'_i$ and $b'_u$ by a time period corresponding to one image line, in order to constitute values $F_i$ and $b_u$.

4. Demodulator according to claim 1, characterized in that the calculating means comprise a calculating device (13 and 19) to calculate the value $b_u$ in function of the variation speed of the modulation signal and in function of two logic signals A and B, and correction means (18') comprising : two pass-bands filters (20 and 21) each having two control inputs respectively connected to the first and the second output of the control device (15') in order to adjust the central frequency to the value $F_i$ and their width of passing band respectively to values $0,7 \cdot b_u$ and $1,4 \cdot b_u$, each having a common signal input with the filter (3) of passing band width $b_u$ and each having an output ; a first, a second and a third detector (22, 23, 24) connected respectively to the outputs of the filters of band width $b_u$, $0,7 \cdot b_u$ and $1,4 \cdot b_u$, in order to determine the energy value of the signals present at these outputs ; a first comparator (25) having two inputs respectively connected to the outputs of the two first detectors (22 and 23) and having an output supplying the logic signal A to the calculating device (13 and 19) when the energy detected by the first detector is equal to the energy detected by the second detector ; a second comparator (26) having two inputs respectively connected to the outputs of the first and the second detectors (22 and 24) and having an output supplying the logic signal B to the calculating device (13 and 19) when the energy detected by the first detector is lower than the energy detected by the third detector ; in that, if the calculating device (13 and 19) receives the logic signal A, the value $b_u$ that it supplies is smaller than in the absence of signal A ; and in that, if the calculating device (13 and 19) receives the logic signal B, the value $b_u$ that it supplies is higher than in the absence of the signal B.

5. Demodulator according to claim 2, characterized in that the estimation device (18) comprises : a collector (6) having an input coupling to the output of the frequency discriminator (4) ; an analogue to digital converter (7) having an input coupled to the output of the collector (6) ; a delay device (14) having an input receiving the value $F_i$ and an output, to restitute this value $F_i$ with a delay such that it corresponds to the same sample of the modulated signal as the value supplied by the output of the converter (7) ; and the subtractor (9) having a first and a second input respectively coupled to the output of the analogue to digital converter (7) and at the output of the delay device (14) and one output coupled to the second input of the sommator (8) in order to supply it the value $\delta b'_u$.

## Ansprüche

1. Demodulator für ein frequenzmoduliertes Signal, das folgende Elemente aufweist : Filtriermittel (3) mit einem ersten und zweiten Steuereingang, einem das zu demodulierende Signal empfangenden dritten Eingang und einem Ausgang ; einen Frequenzdiskriminator (4) mit einem mit dem Ausgang der Filtriermittel (3) verbundenen Eingang und mit einem das Modulationssignal wiedergebenden Ausgang ; eine Steuervorrichtung (15 oder 15') mit einem ersten und einem zweiten Ausgang, welche jeweils mit den ersten und zweiten Ausgängen der Filtriermittel (3) verbunden sind, um jeweils ihre Zentralfrequenz oder ihre Bandbreite in Abhängigkeit der momentanen Frequenz $F_i$ des modulierten Signals und der Variationsgeschwindigkeit dieser Frequenz $F_i$ zu steuern, dadurch gekennzeichnet, dass die Filtriermittel (3) einen Bandfilter (3) mit steuerbaren Zentralfrequenz und Bandbreite aufweist, und dass die Steuervorrichtung (15 oder 15') Rechenmittel aufweist, um einen Wert $b_u$ der vom modulierten Signal belegten Frequenzbandbreite in Abhängigkeit der Variationsgeschwindigkeit des modulierten Signals zu berechnen, und um am zweiten Ausgang der Steuervorrichtung (15 oder 15') ein von diesem Wert $b_u$ abhängiges Signal zu liefern, damit die Bandbreite des Filters (3) auf den Wert $b_u$ eingestellt werden kann.

2. Demodulator nach Anspruch 1, dadurch gekennzeichnet, dass die Rechenmittel folgende Elemente aufweisen : eine Rechenvorrichtung (13 und 19) zur Berechnung eines angenäherten Wertes $b'_u$ der durch das modulierte Signal belegten momentanen Frequenz-Bandbreite, und eine Vorrichtung (18) zur Abschätzung eines Absolutwertes $\delta b'_u$ des den Wert $b'_u$ betreffenden Fehlers, wenn dieser nach unten mit einem Fehler belegt ist ; dass dieser Wert $\delta b'_u$ dadurch geschätzt wird, dass die Differenz gemacht wird zwischen dem Modulationssignal, das aus dem durch den Filter (3) filtrierten modulierten Signal erhalten wird und dem Modulationssignal, das aus dem nicht filtrierten modulierten Signal erhalten wird ; und dass die Rechenmittel einen Addierer (8) aufweisen, mit einem ersten und zweiten Eingang, welche jeweils die Werte $b'_u$ und $\delta b'_u$ empfangen und mit einem Ausgang, der den Wert $b_u = b'_u + \delta b'_u$ abgibt.

3. Demodulator nach Anspruch 1, um ein Fernsehsignal zu demodulieren, dadurch gekennzeichnet, dass die Rechenmittel folgende Vorrichtungen aufweisen : eine erste Rechenvorrichtung (6 und 7), um einen Wert $F'_i$ der momentanen Frequenz des modulierten Signals zu liefern, und eine zweite Rechenvorrichtung (31 und 32) um einen Wert $b'_u$ der durch das modulierte Signal belegten momentanen Bandbreite zu liefern, und eine Verzögerungsvorrichtung (30), welche die Werte $F'_i$ und $b'_u$ um eine Zeit vergrössert, die einer Bildzeile entspricht, um die Werte $F_i$ und $b_u$ aufzubauen.

4. Demodulator nach Anspruch 1, dadurch gekennzeichnet, dass die Rechenmittel eine Rechenvorrichtung (13 und 19) zur Berechnung des Wertes $b_u$ in Abhängigkeit von der Variationsgeschwindigkeit des Modulationssignals und von zwei logischen Signalen A und B, und Korrektions-Mittel (18') aufweisen, welche letztere folgende Elemente beinhalten : zwei Bandfilter (20 und 21), von denen jeder zwei Steuereingänge hat, die jeweils mit dem ersten und zweiten Ausgang der Steuervorrichtung (15') verbunden sind um ihre Zentralfrequenz auf den Wert $F_i$ und ihre Bandbreite jeweils auf die Werte $0,7 \cdot b_u$ und

$1,4 \cdot b_u$ einzustellen, wobei diese beiden Bandfilter (20 und 21) jeder einen mit dem Filter (3) der Bandbreite $b_u$ gemeinsamen Signaleingang und jeder einen Ausgang haben ; einen ersten, zweiten und dritten Gleichrichter (22, 23, 24), welche jeweils mit den Ausgängen der Filter der Bandbreite $b_u$, $0,7 \cdot b_u$ und $1,4 \cdot b_u$ verbunden sind, um den Energiewert der an diesen Ausgängen sich befindenden Signalen zu bestimmen ; einen ersten Komparator (25) mit zwei Eingängen, die jeweils mit den Ausgängen der zwei ersten Gleichrichter (22 und 23) verbunden sind und mit einem Ausgang, der der Rechenvorrichtung (13 und 19) das logische Signal A liefert, wenn die durch den ersten Gleichrichter aufgewiesene Energie gleich der vom zweiten Gleichrichter aufgewiesene Energie ist ; einen zweiten Komparator (26) mit zwei Eingängen, die jeweils mit den Ausgängen des ersten und dritten Gleichrichters (22 und 24) verbunden sind und mit einem Ausgang, der der Rechenvorrichtung (13 und 19) das logische Signal B liefert, wenn die durch den ersten Gleichrichter aufgewiesene Energie geringer als die vom dritten Gleichrichter aufgewiesene Energie ist ; dadurch, dass wenn die Rechenvorrichtung (13 und 19) das logische Signal A empfängt, der von ihr gelieferte Wert $b_u$ geringer ist als in Abwesenheit des Signals A ; und dadurch, dass wenn die Rechenvorrichtung (13 und 19) das logische Signal B empfängt, der von ihr gelieferte Wert $b_u$ grösser als in Abwesenheit des Signals B ist.

5. Demodulator nach Anspruch 2, dadurch gekennzeichnet, dass die Abschätzungsvorrichtung (18) folgende Element aufweist : einen Abtaster (6) mit einem mit dem Ausgang des Frequenzdiskriminator (4) verbundenen Eingang ; einen Analog-Digital-Umsetzer (7) mit einem mit dem Ausgang des Abtasters (6) verbundenen Eingang ; eine Verzögerungs-Vorrichtung (14) mit einem den Wert $F_i$ empfangenden Eingang, und einem Ausgang, um diesen Wert $F_i$ mit einer solchen Verzögerung wiederzugeben, dass er demselben abgetasteten modulierten Signal entspricht wie der durch den Ausgang des Umsetzers (7) gelieferte Wert ; und einen Substraierer (9) mit einem ersten und zweiten Ausgang, die jeweils mit dem Ausgang des Analog-Digital-Umsetzers (7) und dem Ausgang der Verzögerungs-Vorrichtung (14) verbunden sind, und mit einem Ausgang, der an den zweiten Eingang des Addierers (8) gekoppelt ist, um ihm den Wert $\delta b'_u$ zu liefern.

FIG.1

FIG.2

# FIG.3

0 048 661